# EUROPEAN PATENT APPLICATION

(11) **EP 1 876 190 A1**
(43) Date of publication of application: **09.01.2008**
(21) Application number: 05819796.3
(22) Date of filing: 22.12.2005
(51) Int. Cl.: C08F 220/10, C08F 220/06, G03F 7/039, G03F 7/11, H01L 21/027

(54) **ACRYLIC COPOLYMER**

(30) Priority: 27.12.2004 JP 2004378236
(71) Applicant: TOKYO OHKA KOGYO CO., LTD., Kawasaki-shi, Kanagawa 211-0012 (JP); HARIMA CHEMICALS, INC., Kakogawa-shi, Hyogo 675-0019 (JP)
(72) Inventor: ENDO, Kotaro, TOKYO OHKA KOGYO CO., LTD., Kawasaki-shi, Kanagawa, 211-0012 (JP); ISHIDUKA, Keita, TOKYO OHKA KOGYO CO., LTD., Kawasaki-shi, Kanagawa, 211-0012 (JP); HIRANO, Tomoyuki, TOKYO OHKA KOGYO CO., LTD., Kawasaki-shi, Kanagawa 211-0012 (JP); TANINAKA, Ichiro, HARIMA CHEMICALS, INC., Kakogawa-shi, Hyogo, 675-0019 (JP); TSUKUDA, Takahiko, HARIMA CHEMICALS, INC., Kakogawa-shi, Hyogo, 675-0019 (JP)
(74) Representative: Cabinet Plasseraud
(86) International application number: PCT/JP2005/023636
(87) International publication number: WO 2006/070694

(57) **Abstract**

It is intended to in a liquid-immersion exposure process, simultaneously prevent any degeneration, represented by bridge, etc., of resist film during the liquid-immersion exposure using water and other various liquid-immersion exposure liquids and any degeneration of liquid-immersion exposure liquids per se, and to without increasing of the number of treatment steps, realize enhancing of the post-exposure storage stability of resist film, and to enable forming of a resist pattern of high resolution through liquid-immersion exposure. Use is made of an acrylic copolymer of the general formula: 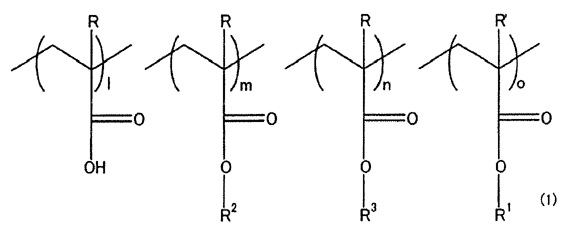 wherein R is a hydrogen atom or methyl; R' is a hydrogen atom, methyl or C₁-C₄ hydroxyalkyl; R¹ is a C₁-C₁₅ linear, branched or cyclic alkyl with the proviso that the hydrogen atoms of the alkyl may be partially or wholly substituted with fluorine atom or atoms; R² is an alicyclic hydrocarbon group; R³ is a linear hydrocarbon group; and each of 1, m, n and o is the mol% of structural unit contained, being in the range of 2 to 60 mol%.

## Description

### TECHNICAL FIELD

The present invention relates to an acrylic copolymerized polymer which can be suitably used for materials for forming a resist protective film that form a protective film of resist films. Particularly, the present invention relates to an acrylic copolymerized polymer which can be suitably used for materials for forming a resist protective film used in a liquid immersion lithography process, in particular, liquid immersion lithography process in which the resolution of a resist pattern is improved by exposing a resist film while allowing a liquid (hereinafter, referred to as liquid for liquid immersion lithography) having a refractive index which is higher than that of an air and lower than that of the resist film to be lied in a predetermined thickness on at least the resist film in a path through which lithographic exposure light reaches to the resist film.

### BACKGROUND ART

Conventionally, lithography has been commonly used in fabricating fine structures in various kinds of electronic devices such as semiconductor devices and liquid crystal devices. However, along with the miniaturization of device structures, there is a need for micro-fabrication of resist patterns in a lithography process.

In the advanced field, for example, a lithography process now allows the formation of a fine resist pattern having a line width of about 90 nm. However, finer pattern formation will be required in future.

For attaining the formation of such a fine pattern having a line width of less than 90 nm, a first point is to develop an aligner and a resist corresponding thereto. Common factors to consider for developing the aligner include shortening of wavelengths of optical sources such as F2 excimer laser, EUV (extreme UV light), electron beam, X-ray, and soft X-ray, and increases in numerical aperture (NA) of lens.

On the other hand, not only does shortening the wavelengths of the light sources require a new and expensive photolithography machine, but also a problem arises when increasing the NA; in that a focal depth width is reduced even if the resolving ability is improved, because a trade-off lies between increasing the resolving ability and the focal depth width.

Recently, as a lithography technique enabling the solution of such problems, a method referred to as liquid immersion lithography has been reported (for example, see Non-patent documents 1 to 3). In this process, a liquid for liquid immersion lithography such as pure water or a fluorine-based inert liquid lies in predetermined thickness on at least a resist film between a lens and the resist film during the exposure. In this method, the space of the path of exposure light, which is conventionally filled with inert gas such as air or nitrogen, is replaced with a liquid having a higher refractive index (n), for example purified water, to attain high resolution without a decrease in focal depth width, similar to the use of a light source of shorter wavelength or a high NA lens, even if an optical source having the same exposure wavelength is employed.

Such liquid immersion lithography has been remarkably noticed because the use thereof allows a lens implemented in the existing device to realize the formation of a resist pattern excellent in higher resolution property as well as excellent in focal depth in low costs.
Non-Patent Document 1: Journal of Vacuum Science & Technology B (J. Vac. Sci. Technol. B) (Issued country: U.S.A.), Vol. 17, No. 6, pages 3306-3309, 1999.
Non-Patent Document 2: Journal of Vacuum Science & Technology B (J. Vac. Sci. Technol. B) (Issued country: U.S.A.), Vol. 19, No. 6, pages 2353-2356, 2001.
Non-Patent Document 3: Proceedings of SPIE (Issued country: U.S.A.), Vol. 4691, pages 459-465, 2002.

### DISCLOSURE OF THE INVENTION

### Problems to be Solved by the Invention

However, in the abovementioned liquid immersion lithography process, since a resist film is directly brought into contact with a liquid for liquid immersion lithography at the time of exposure, the resist film is permeated by the liquid. Therefore, it is necessary to examine whether the resist composition that has been used conventionally can be applied as it is.

The resist composition, which has been commonly used in the art, is a composition established by widely investigating any of the potential resins which is able to miniaturize its resist pattern. The present inventors have studied by various tests so as to obtain a resist composition having characteristics suited for liquid immersion lithography with slightly or no adjusting the compositions proposed at present. As a result, the existence of a resist composition that is able to meet the abovementioned expectations from a practical standpoint was revealed. On the other hand, it was also confirmed that there exist many cases in which even though a resist composition is used that cannot achieve satisfactory pattern resolution property in liquid immersion lithography due to deterioration caused by the liquid for liquid immersion lithography, fine and excellent resolution property is exhibited by common lithography in which the exposure is conducted through an air layer. Such a resist composition is a composition attained by consuming a lot of development resources and is a composition which is excellent in various resist characteristics such as transparency to exposure light, developing properties, and storage stability, and such resist compositions include any of compositions which is inferior only in resistance to a- liquid for liquid immersion lithography. Some examples of a composition, which is not suited for liquid immersion lithography but exhibits high resolution in lithography in an air layer, are shown in the examples and comparative examples of the present invention, described hereinafter.

In addition, even if the abovementioned resist film appropriate to the liquid immersion lithography is used, it has been confirmed that the liquid immersion lithography deteriorates the quality, and yield of good products, as compared to the exposure through an air layer.

The present invention has been made in view of such problems associated with conventional techniques. An objective of the present invention is to provide a technique enabling the application of the resist film obtained from conventional resist compositions, which have required many development resources to the liquid immersion lithography. In this liquid immersion lithography, there are problems of permeation of the resist film by liquid for liquid immersion lithography and the outflow of the resist ingredient to liquid for liquid immersion lithography. When the change in quality of such a resist film occurs, a desired resist pattern is not obtained, therefore it is fatal to manufacture semiconductor element.

The objective of this invention is to enable the formation of a resist pattern with higher resolving ability using liquid immersion lithography by using a specific acrylic copolymerized polymer as a copolymerized polymer for forming a protective film especially formed on the surface of resist film so as to simultaneously prevent the deterioration of the resist film and that of the liquid for liquid immersion lithography used during the liquid immersion lithography and solve above mentioned problems.

### Means for Solving the Problems

To solve the problem, an acrylic copolymerized polymer of the present invention is represented by following general formula (1) 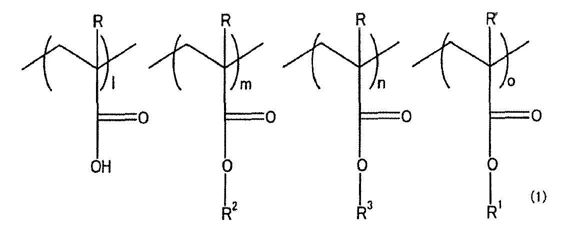 wherein R is a hydrogen atom or a methyl group, R' is a hydrogen atom, a methyl group, or a hydroxyalkyl group having 1 to 4 carbon atoms. R¹ is a linear, branched or cyclic alkyl group having 1 to 15 carbon atoms, and a portion or all of hydrogen atoms thereof may be substituted with fluorine atoms. R² is an alicyclic hydrocarbon group, R³ is a chain hydrocarbon group, and 1, m, n, and o each representing % by mole of the constituent unit in the polymer, are each 2 to 60% by mole.

The acrylic copolymerized polymer is preferably included in a material for forming a protective film as an upper layer on a resist film, and preferably the resist film is one subjected to liquid immersion lithography.

### Effects of the Invention

Use of the acrylic copolymerized polymer of the present invention as a material for forming a protective film enables to suppress permeation of the resist film by a liquid for liquid immersion exposure and the outflow of the resist ingredient to the liquid for liquid immersion lithography. Therefore in an aspect of the present invention, it is possible to provide a material for forming a resist protective film which can form a protective film capable of surely protecting a resist film from a liquid for liquid immersion exposure in liquid immersion lithography.

The material for forming a protective film including the acrylic copolymerized polymer of the present invention can be directly formed on a resist film and does not inhibit pattern exposure. In addition, the material for forming the protective film of this invention is insoluble in water so as to enable the use of "water (pure water or deionized water) which is most likely to be the liquid for liquid immersion lithography process because of the optical requirements of liquid immersion lithography, easy handling, and no risk in polluting the environment" as the liquid for liquid immersion lithography process in practice. In other words, even when water, which is easy to handle, has an excellent refractive index property and no risk of environmental pollution, is used as an immersion liquid for the liquid immersion lithography process, the material of the present invention sufficiently protects resist films of various compositions during the liquid immersion lithography process so that the resist patterns having excellent properties can be obtained. In addition, when the exposure light with a wavelength of 157 nm is used, a fluorine-based medium is likely to be the liquid for liquid immersion lithography from the viewpoint of the exposure light absorption. Even when such a fluorine-based solvent is used, similarly to water mentioned above, the material sufficiently protects the resist film during liquid immersion lithography process so that the resist pattern with excellent properties can be obtained. Furthermore, since the material for forming a protective film according to the present invention is alkali-soluble, it is unnecessary to remove the formed protective film from the resist film prior to the development process even when the light exposure is completed reaching the step of development process. That is, by using the protective film obtained using the material for forming a protective film according to the present invention, it is unnecessary to provide a step of removing the protective film prior to the development process after exposure, whereby the development process for the resist film with an alkaline developer solution can be performed as the protective film remains, so that the protective film removal and the resist film development can be simultaneously accomplished. Therefore, the method for forming a pattern using the material for forming a protective film according to the present invention can efficiently perform the formation of the resist film with an excellent pattern property keeping the environmental pollution risk extremely low and reducing the number of processes.

### BRIEF DESCRIPTION OF THE DRAWINGS

FIG. 1 is a figure which shows the NMR chart of the copolymerized polymer (8) of the present invention.
FIG. 2 is a figure which shows the FT-IR chart of the copolymerized polymer (8) of the present invention.
FIG. 3 is a figure which shows the NMR chart of the copolymerized polymer (9) of the present invention.
FIG. 4 is a figure which shows the FT-IR chart of the copolymerized polymer (9) of the present invention.

### DENOTATION OF REFERENCE NUMERALS

A1: An NMR peak peculiar to the carbonyl carbon of acrylic acid
B1: An NMR peak peculiar to a fluorine substituted carbon atom
C1: An NMR peak peculiar to a carbon atom of the dicyclopentanyl group bound to an oxygen atom of methacryl
D1: An NMR peak peculiar to a carbon atom of the cyclohexyl group bound to an oxygen atom of methacryl
E1: An NMR peak peculiar to a carbon atom of the n-butyl group bound to an oxygen atom of acryl
F1: An NMR peak peculiar to a carbon atom of the heptadecafluorodecyl group bound to an oxygen atom of acryl
A2: An NMR peak peculiar to the carbonyl carbon of acrylic acid
B2: An NMR peak peculiar to a carbon atom of the dicyclopentanyl group bound to an oxygen atom of methacrylic acid
C2: An NMR peak peculiar to a carbon atom of the cyclohexyl group bound to an oxygen atom of methacrylic acid
D2: An NMR peak peculiar to a carbon atom of the n-butyl group bound to an oxygen atom of acrylic acid
E2: An NMR peak peculiar to a carbon atom of the heptadecafluorodecyl group bound to an oxygen atom of acryl

### PREFERRED MODE FOR CARRYING OUT THE INVENTION

The acrylic copolymerized polymer according to the present invention is represented by the general formula (1) below. 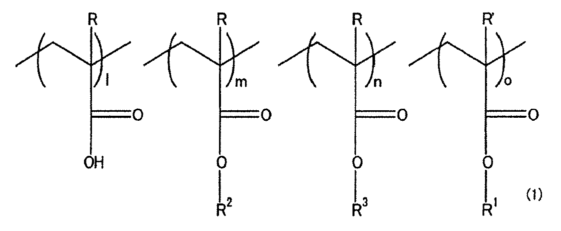 wherein R is a hydrogen atom or a methyl group, R' is a hydrogen atom, a methyl group, a hydroxyalkyl group having 1 to 4 carbon atoms. R¹ is a linear, branched or cyclic alkyl group having 1 to 15 carbon atoms, a portion or all of hydrogen atoms thereof may be substituted with fluorine atoms. R² is an alicyclic hydrocarbon group, R³ is a chain hydrocarbon group and 1, m, n, and o each representing % by mole of the constituent unit in the polymer, are each 2 to 60% by mole. The coupling structure of each constituent unit may be either random copolymerization or block copolymerization, but the generally obtained polymer has a structure of the random copolymer.

The acrylic copolymerized polymer has an effect of suppressing permeation of the resist film by the liquid for liquid immersion exposure and the outflow of the resist ingredient to the liquid for liquid immersion lithography. Therefore using the acrylic copolymerized polymer enables to simultaneously prevent deterioration of a resist pattern and the liquid itself. Therefore, it is possible to provide a material for forming a resist protective film forming a protective film capable of surely protecting a resist film from a liquid for liquid immersion lithography in liquid immersion lithography.

In a first embodiment, R' is preferably a hydroxyalkyl group having 1 to 4 carbon atoms in the above mentioned general formula (1). When the acrylic copolymerized polymer according to this first embodiment is included in a material for forming a protective film, a hydroxyl group of the R' reacts to form an intermolecular bond. The film is densified by this bond thereby making it possible to suppress permeation of a resist film by a liquid for liquid immersion lithography, and to effectively prevent penetration of an amine component contained in an atmosphere into a resist film. Therefore, the stability to post exposure delay of resist pattern is enhanced.

Examples of hydroxyalkyl group include linear hydroxyalkyl groups such as an α-hydroxymethyl group, a β-hydroxyethyl group, and a γ-hydroxypropyl group; and branched hydroxyalkyl group such as a 2-hydroxyethyl group. Among these, α-hydroxymethl group is preferable because of better reactivity of the hydroxyl group, and improvement of the film density. Even more particularly, R¹ in this embodiment is a linear, branched or cyclic alkyl group having 1 to 15 carbon atoms, and preferably a methyl group or an ethyl group.

In the first embodiment, the monomer used as a constituent unit having R' includes ethyl(α-hydroxymethyl) acrylate, methyl(α-hydroxymethyl) acrylate.

Furthermore, in a second embodiment, R¹ in the above general formula (1) is preferably an organic group represented by the following general formula (2):

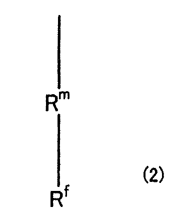

In the above mentioned general formula (2), R^{m} is a linear or branched alkylene group having 1 to 5 carbon atoms, and R^{f} is an alkyl group having 1 to 12 carbon atoms, and a portion or all of hydrogen atoms thereof are substituted with a fluorine atom. Furthermore, R' in this embodiment is a hydrogen atom or a methyl group.

When the acrylic copolymerized polymer according to the second embodiment is included in a material for forming a protective film, contact angles of the acrylic copolymerized polymer with water become not less than 90 degrees by the introduction of the fluorine atom to R^{f}. Therefore it has an advantage to be able to perform the exposure processing of the substrate end easily without leakage of the liquid for liquid immersion lithography outside the substrate.

Furthermore, the protective film formed using the acrylic copolymerized polymer according to the second embodiment is also advantageous in that the amount of the liquid for liquid immersion lithography that adhere to the protective film is reduced; so that a time period required for cleaning after the completion of liquid immersion lithography process is shortened.

R^{m} includes, for example, a linear alkylene group such as a methylene group, a n-ethylene group, a n-propylene group, a n-butylene group, and a n-pentylene group; branched alkylene groups such as a 1-methylethylene group, a 1-methylpropylene group, and a 2-methylpropylene group. Among them, a methylene group and a n-ethylene group are preferable.

Specific examples of R^{f} include a trifluoromethyl group, a pentafluoroethyl group, a heptafluoropropyl group, a nonafluorobutyl group, an undecafluoropentyl group, a heptadecafluorooctyl group, and the like. Among these, in terms of increase in the contacting angle, a heptadecafluorooctyl group is preferable.

The R^{f} may have either a linear, branched or cyclic structure.

In the second embodiment, the monomer used as a constituent unit having R¹ includes heptadecafluorodecyl methacrylate, trifluoroethyl methacrylate, octafluoropentyl methacrylate, and the like. If these monomers are transcribed in a rational formula, for example, the heptadecafluorodecyl methacrylate is represented as CH₂=C(CH₃)COO(CH₂)₂(C)₈F, the trifluoroethyl methacrylate is represented as CH₂=C(CH₃)COOCH₂CF₃, octafluoropentyl methacrylate is represented as CH₂=C(CH₃)COOCH₂(CF₂)₄H.

In the general formula (1), the constituent unit having R² is constructed with a constituent unit having R^{2a} and R^{2b} wherein R^{2a} is a polycyclic hydrocarbon group, and R^{2b} is a monocyclic hydrocarbon group. By introducing an alicyclic hydrocarbon group such as a polycyclic hydrocarbon group and a monocyclic hydrocarbon group to R², water resistance and transparency of the acrylic copolymerized polymer is improved.

The R^{2a} includes, for example, a polycyclic hydrocarbon group such as a dicyclopentanyl group, an adamantyl group, a norbonyl group, an isobornyl group, a tricyclodecyl group and a tetracyclododecyl group.

The R^{2b} includes, for example, a monocyclic hydrocarbon group such as a cyclohexyl group, a cyclopentyl group and a cycloheptyl group.

In the general formula (1), R³ is a chain hydrocarbon group, and by introducing the chain hydrocarbon group to R³, moderate flexibility can be imparted to the protective film.

The R³ includes, for example, a chain hydrocarbon group such as, a n-butyl group, a n-pentyl group, a 2-ethylhexyl group, and a n-hexyl group.

As the acrylic copolymerized polymer of the first embodiment of the present invention, a polymer represented by the following general formula (3) is preferable.

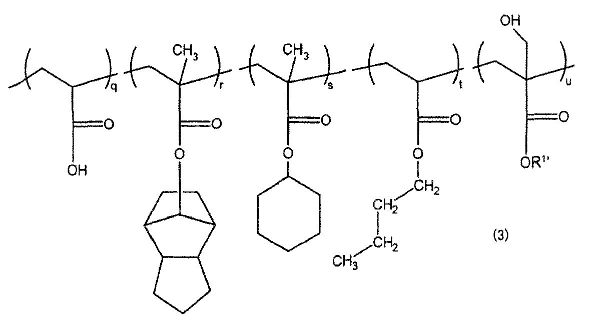

In the general formula (3), R¹' is a methyl group or an ethyl group, and q, r, s, t, and u each representing % by mole of the constituent unit in the polymer, are each 2 to 60% by mole.

The acrylic copolymerized polymer of the second embodiment of the present invention is preferably a polymer represented by the following general formula (4).

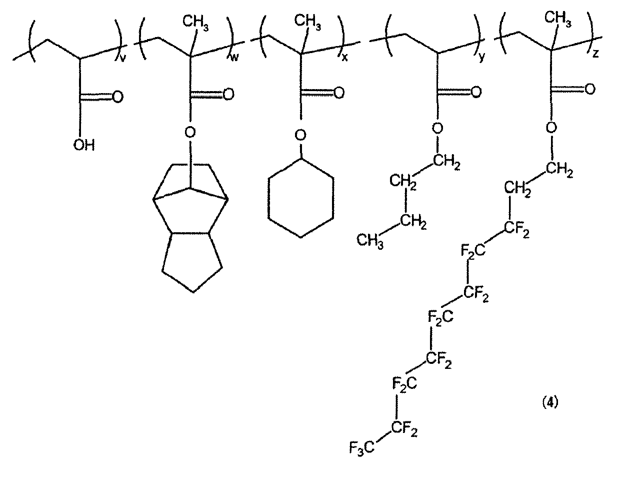

In the general formula (4), v, w, x, y, and z each representing % by mole of the constituent unit in the polymer, are each 2 to 60% by mole.

The manufacturing method of the acrylic copolymerized polymer according to the present invention is explained below. The acrylic copolymerized polymer represented by the general formula (1) can be obtained by a copolymerization reaction by adding an polymerization initiator to a mixture of (meth)acrylic acid, (meth)acrylic ester represented by the following general formula (5) below, 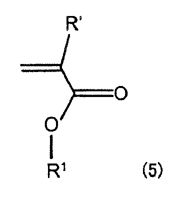 (wherein R' is a hydrogen atom, a methyl group, or a hydroxyalkyl group having 1 to 4 carbon atoms, R1 is a linear, branched or cyclic alkyl group having 1 to 15 carbon atoms, a portion or all of hydrogen atoms thereof may be substituted with fluorine atoms.) and (meth)acrylic ester represented by following general formulae (6) and (7). 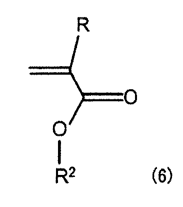 wherein, R2 is an alicyclic hydrocarbon group, 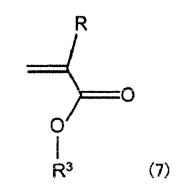 wherein, R3 represents a chain hydrocarbon group.

In the general formula (6), the constituent unit having R² is constructed with a constituent unit having R^{2a} and R^{2b} wherein R^{2a} is a polycyclic hydrocarbon group, and R^{2b} is a monocyclic hydrocarbon group.

Examples of a solvent used in the polymerization reaction include alcoholic solvents, paraffinic solvents and fluorine-based solvents. Among these, the alcoholic solvent is preferable and a common alcoholic solvent such as isopropyl alcohol, 1-hexanol, 2-methyl-1-propanol or 4-methyl-2-pentanol can be used, and 2-methyl-1-propanol is particularly preferable.

The polymerization initiator includes, for example, benzoyl peroxide, tert-butylperoxy 2-ethyl hexanoate, 1,1,3,3,-tetramethylbutylperoxy 2-ethylhexanoate, tert-butylhydroperoxide, and the like. Among these, benzoyl peroxide and 1,1,3,3,-tetramethylbutylperoxy 2-ethyl hexanoate are preferable from the point of the water resistance.

The reaction temperature of the copolymerization reaction is preferably in the range of 70°C to 90°C and more preferably 75°C to 85°C.

The reaction time of the copolymerization reaction is preferably 6-12 hours, and generally, the reaction can be carried out by dripping for 1-5 hours, then further allowing a reaction for 3-5 hours after dripping, followed by elevating the temperature to allow the reaction for additional 1-2 hours.

The weight average molecular weight (Mw) of the acrylic copolymerized polymer obtained by the aforementioned copolymerization reaction can be determined by GPC (gel permeation chromatography). The mass average molecular weights of resins of the polymer components (by GPC, polystyrene conversion) is preferably in the range of 5,000 to 80,000, and more preferably 8,000 to 50,000, but not particularly limited to such a range.

The copolymerized polymer is soluble in an alcoholic solvent, can form a film by a spin coater, causes neither swelling nor thickness loss to the liquid for liquid immersion lithography within a time sufficient for liquid immersion lithography, and is also soluble in an alkaline developing solution. That is, the polymer is highly suited for use as a resist protective film material for liquid immersion lithography. Moreover, the copolymerized polymer has a high refractive index of 1.65, when permeated by light having a wavelength of 193 nm.

The liquid immersion lithography process is characterized in that the resolution of a resist pattern is improved by exposing a resist film while allowing a liquid for liquid immersion lithography to be lied on at least the resist film in a path through which lithographic exposure light reaches to the resist film.

The exposure light for exposing the resist film preferably has a dominant wavelength which is at least one selected from 157 nm 193 nm and 248 nm.

In the present invention with the above constitution, liquid immersion lithography can be conducted by using, as a liquid for liquid immersion lithography, water composed substantially of pure water or deionized water, or a fluorine-based inert liquid. As described previously, taking into account the cost, the ease of post-treatment and the reduction in environmental pollution, water is a more preferable liquid for liquid immersion lithography. When exposure light having a wavelength of 157 nm is used, it is preferable to use a fluorine-based solvent which causes less absorption of exposure light. Furthermore, the protective film formed from the material for forming a resist protective film of the present invention is dense, can suppress permeation of the resist film by a liquid for immersion lithography, and also can prevent permeation of an amine component in an atmosphere, thereby capable of imparting the resistance to post exposure delay required for the resist film.

The resist film, which can be used in the present invention, may be any resist film obtained by using a conventional common resist composition, and is not specifically limited. This is also a primary feature of the present invention.

The protective film formed from the aforementioned material is nonaqueous and also exhibits high resistance to other liquid for liquid immersion lithography, and therefore can be applied to a resist film with any composition, including a resist film having low resistance to the liquid for liquid immersion lithography. Therefore, as the resist film material of the present invention, any known resist can be used and a common positive photoresist and a negative photoresist can be used.

A resist pattern forming method by the liquid immersion lithography using the aforementioned protective film will now be described. First, a common resist composition is coated onto a substrate such as silicone wafer using a spinner or the like, and then prebaked (PAB treatment). An organic or inorganic antireflective film can be provided between the substrate and the coating layer of a resist composition, to form a two-layered laminate.

The above processes can be conducted by a known method. It is preferable that the operation conditions are appropriately set depending on the composition and characteristics of the resist composition used.

Next, the resist protective film is formed by uniformly coating a material composition for forming a protective film on the surface of a resist film (single layer, plural layers), followed by curing.

The substrate, on which a resist film covered with the protective film is formed, is immersed in a liquid for immersion liquid lithography (pure water, deionized water, fluorine-based solvent or a silica-based solvent in the case specialized in the present invention).

The resist film on the substrate in this immersed state is selectively exposed via a desired mask pattern. Accordingly, exposure light penetrates into the liquid for liquid immersion lithography and protective film, then reaching to the resist film at this time.

At this time, the resist film is completely shut off from the liquid for liquid immersion lithography such as pure water, by the protective film, and thus deterioration such as swelling is not caused by permeation of the liquid for liquid immersion lithography. In addition, the optical characteristics such as the refractive index of the liquid for liquid immersion lithography are not deteriorated as a result of dissociation of a component in the liquid for liquid immersion lithography.

The wavelength of light used in the exposure is not specifically limited, and the exposure can be conducted by using radiation such as that of an ArF excimer laser, KrF excimer laser, F₂ excimer laser, EUV (extreme ultraviolet ray), VUV (vacuum ultraviolet ray), electron beam, X-ray and soft X-ray. The kind of radiation is mainly decided depending on characteristics of a resist film.

As described above, in the resist pattern forming method, the liquid for liquid immersion lithography is disposed onto the resist film via a protective film upon exposure. During this operation, the resist film is permeated by being brought into contact with the liquid. However, this permeation can be prevented by using the protective film of the present invention. Examples of such a liquid include water (pure water, deionized water), or a fluorine-based inert liquid. Specific examples of the fluorine-based inert liquid include liquids containing fluorine-based compounds such as C₃HCl₂F₅, C₄F₉OCH₃, C₄F₉OC₂H₅ and C₅H₃F₇ as main components. Among these liquids, in view of cost, safety, environmental problems and general-purpose properties, the use of water (pure water or deionized water) is preferred. When using exposure light having a wavelength of 157 nm, a fluorine-based solvent is preferably used in view of less absorption of exposure light.

The refractive index of the liquid used is not specifically limited as long as it is within a range "which is higher than the refractive index of an air and lower than that of the resist composition used".

After the exposure process in liquid immersion is completed, the substrate is removed from the liquid, and the liquid is removed from the substrate. Although this operation is followed by a development process using an alkaline developing solution, before the development process, curing of the exposed area is promoted by heating the resist film. If the resist film is permeated by an amine in an atmosphere component during this process, a pattern shape after the development process is drastically deteriorated. However, in the present invention, since the protective film is densified by a crosslinking agent, as an essential component of a material for forming a protective film, the amine in an atmosphere component does not permeate the resist film.

As described above, the resist film is subjected to PEB (post exposure bake) without removing the protective film on the exposed resist film, and then developed using an alkaline developing solution composed of an aqueous alkaline solution. The developing solution used in this development treatment is alkaline, and therefore, the protective film is dissolved and discharged; and then the soluble portion of the resist film is dissolved and discharged. The development treatment may be followed by postbaking. Preferably, rinsing is conducted using pure water. In the water rinsing process, water is dripped or sprayed over the surface of the substrate while rotating, thereby washing away the protective film component and the resist composition dissolved by the developing solution, and the developing solution on the substrate. Then, a resist pattern, in which a resist film is patterned in a shape corresponding to a mask pattern, is obtained by drying. As described above, in the present invention, removal of the protective film and the development of the resist film are simultaneously achieved by a single development process.

By forming resist patterns in this way, resist patterns having fine line widths, particularly line-and-space patterns having a small pitch can be produced with good resolution. Here, the term "pitch" in line-and-space patterns refers to a total distance of a resist pattern width and a space width in the line width direction of the pattern.

### EXAMPLES

Hereinafter, examples of the present invention will be described. However, these examples are only provided for appropriately illustrating the present invention and do not intend to restrict the present invention at all.

### <Measurement method of the solid content of copolymerized polymer>

The solid content of the polymerization reaction liquid including copolymerized polymer formed by copolymerization of the (meth)acrylic monomer was determined in terms of a nonvolatile content derived after treating with a hot air drier at 105°C for 3 hours as a solid.

### <Measurement method of the weight average molecular weight (Mw) of the copolymerized polymer>

The weight average molecular weight (Mw) of the (meth) acrylic copolymerized polymer was measured with GPC(gel permeation chromatography). The measurement conditions and measuring device are as shown below.

### <Measurement condition and measuring device>

Device: HLC-8220, manufactured by Tosoh Corporation
Detector: RI
Column: GMHXLX3 HXL-H (guard column) column, manufactured by Tosoh Corporation
Temperature: 40°C
Flow Rate: 1 ml/min
Calibration Curve: Polystyrene
Eluent: THF

### Example 1

### Manufacture of the acrylic copolymerized polymer (8) of the present invention

750 g of isobutyl alcohol was charged into a 2-liter four necked flask equipped with a reflux condenser and a stirrer, and blowing of nitrogen was started. After the temperature was raised to 80°C while stirring, a mixture of methacrylic acid-based monomers containing acrylic acid (60 g), dicyclopentanyl methacrylate (40 g), n-butyl acrylate (40 g), cyclohexyl methacrylate (20 g) and heptadecafluorodecyl methacrylate (40 g); and another mixture of isobutyl alcohol (50 g) as a solvent, and benzoyl peroxide (1.7 g) as a polymerization initiator were dripped into the flask from separate dripping nozzles respectively over 4 hours. The dripping was carried out continuously while maintaining a constant drip rate for each ingredient throughout the dripping.

After the dripping was completed, the polymerization reaction solution was left for aging for 4 hours at 80°C, and again for an additional 1 hour by raising the temperature until reflux of the solvent was observed. Thus, the polymerization reaction was completed, to obtain an acrylic copolymerized polymer represented by the following chemical formula (8). The solid content in the polymerization reaction solution thus obtained was 20.2%, and the weight-average molecular weight (Mw) thereof converted into polystyrene was 20,000.

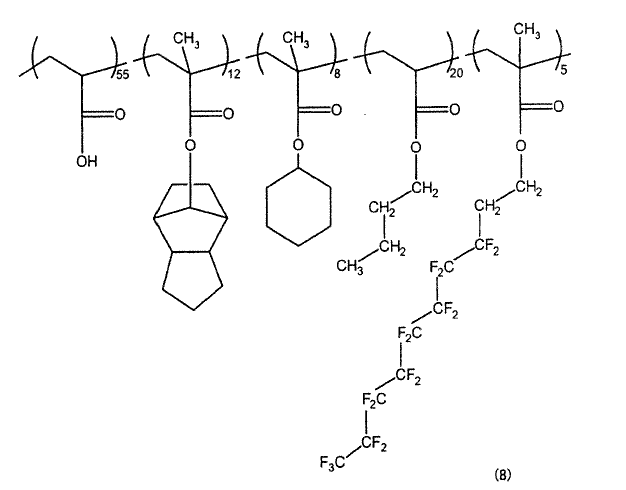

The identification of the resulting acrylic copolymerized polymer was done by NMR analysis and FT-IR analysis. The NMR analysis was done by using NMR analyzer device JNM-AL400 (manufactured by JEOL corporation). Also, the FT-IR analysis was conducted by using an FT-IR analyzer device EXCALIBUR300MX (manufactured by Varian Technologies Japan, Ltd.).

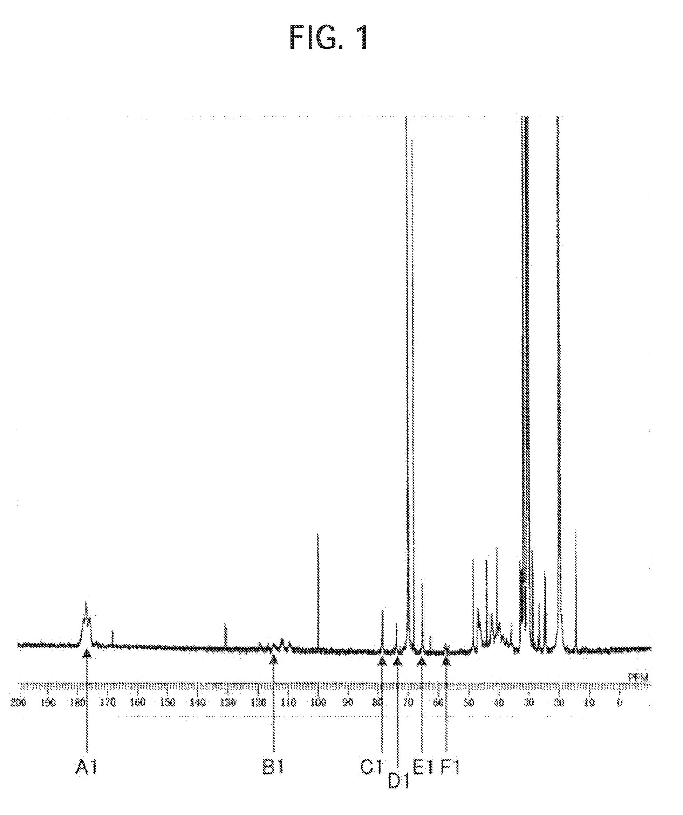

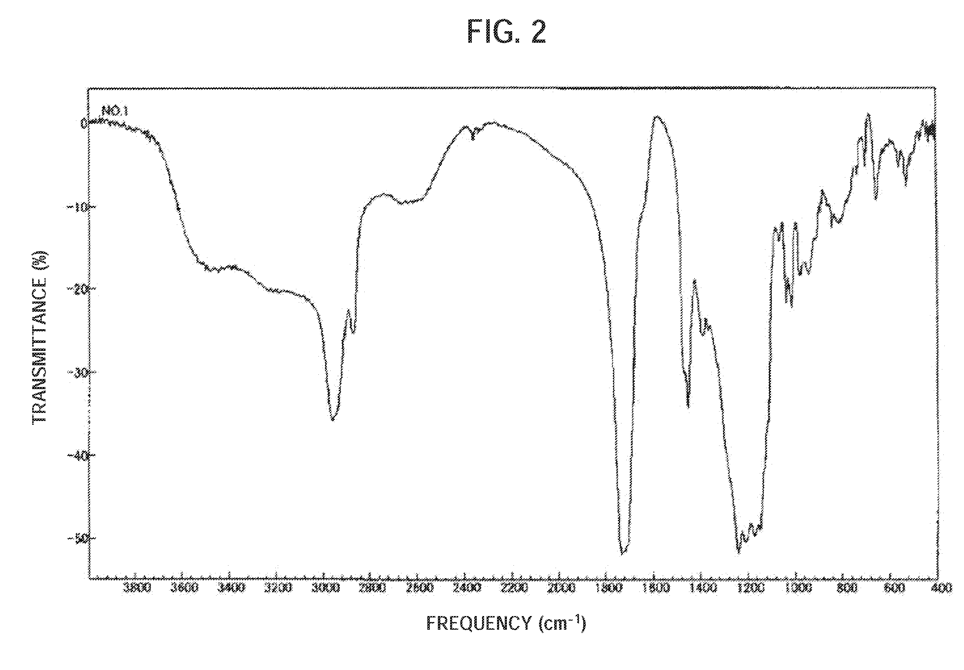

Each analysis results are shown below. Also, each analysis chart is shown in FIG. 1 and 2.

### NMR analysis

By analyzing the NMR spectrum of the copolymer, it was identified as the intended structure from the peak peculiar to each unit (A1: a peak peculiar to the carbonyl carbon of the acrylic acid, B1: a peak peculiar to fluorine substituted carbon atom, C1: a peak peculiar to a carbon atom of dicyclopentanyl bound to an oxygen atom of the methacryl, D1: a peak peculiar to a carbon atom of the cyclohexyl group bound to an oxygen atom of the methacryl, E1: a peak peculiar to a carbon atom of the n-butyl bound to an oxygen atom of the acrylic, F1: a peak peculiar to the heptadecafluorodecyl group bound to an oxygen atom of the acrylic) and its peak ratio, as shown in FIG. 1.

### FT-IR analysis

In the FT-IR spectrum of resulting copolymer, a strong peak attributed to C-F expansion and contraction vibration at the position of 1,213 cm⁻¹ and 1,242 cm⁻¹, and a peak attributed to C-F binding at the position of 704 cm⁻¹ are observed, and the introduce of functional group having C-F binding in a polymer was ensured.

### Example 2

### Manufacture of the acrylic copolymerized polymer (9) of the present invention

750 g of isobutyl alcohol was charged into a 2-liter four necked flask equipped with a reflux condenser and a stirrer, and blowing of nitrogen was started. After the temperature was raised to 80°C while stirring, a mixture of methacrylic acid-based monomers containing acrylic acid (57 g), dicyclopentanyl methacrylate (38 g), n-butyl acrylate (76 g), cyclohexyl methacrylate (19 g) and ethyl (α-hydroxymethyl) acrylate (10 g) (1); and another mixture of isobutyl alcohol (50 g) as a solvent, and benzoyl peroxide (1.7 g) as a polymerization initiator were dripped into the flask from separate dripping nozzles respectively over 4 hours (2). The dripping was carried out continuously while maintaining a constant drip rate for each ingredient throughout the dripping.

After the dripping was completed, the polymerization reaction solution was left for aging for 4 hours at 80°C, and again for an additional 1 hour by raising the temperature until reflux of the solvent was observed. Thus, the polymerization reaction was completed to obtain an acrylic copolymerized polymer of this invention represented by the following chemical formula (9).

The solid content in the polymerization reaction solution thus obtained was 20.3%, and the weight-average molecular weight (Mw) thereof converted into polystyrene was 38,000.

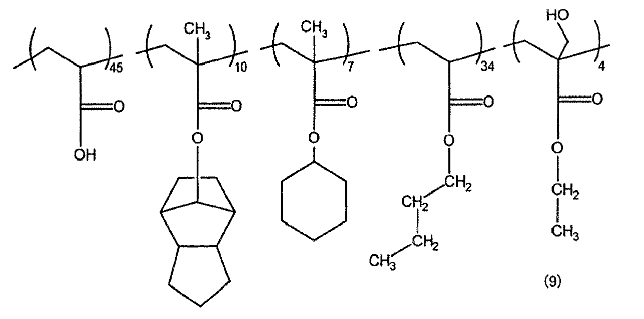

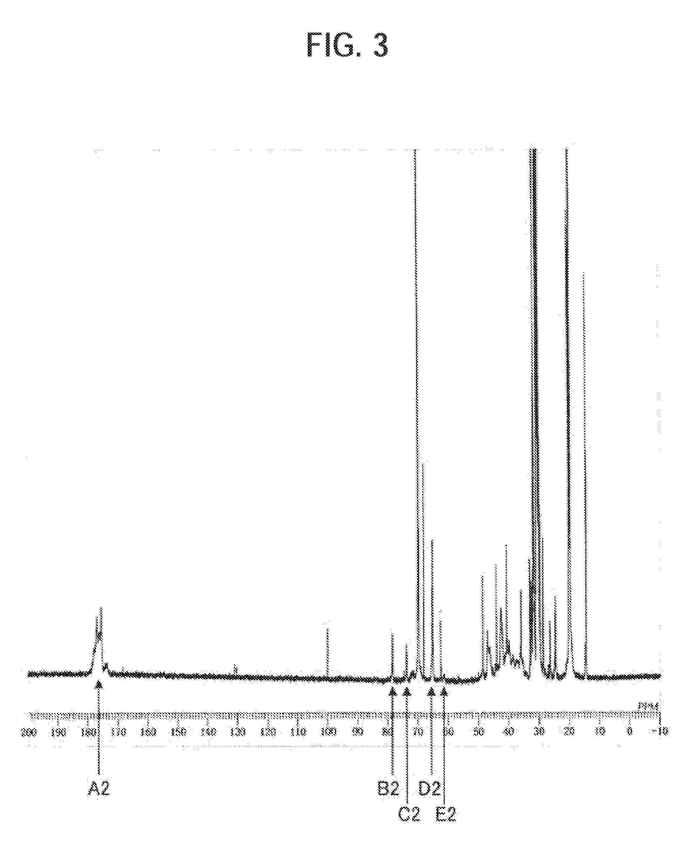

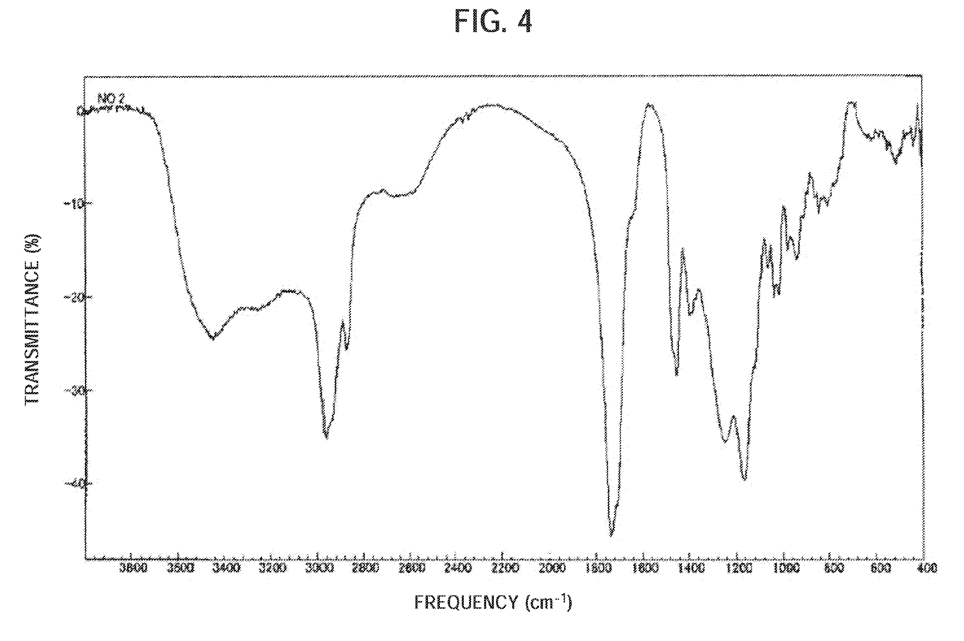

The identification of the resulting acrylic copolymerized polymer was done by NMR analysis and FT-IR analysis similarly to Example 1. Each analysis results are shown below. Also, each analysis chart is shown to FIG. 3 and 4.

### NMR analysis

By analyzing the NMR spectrum of the copolymer, it was identified as the intended structure from the peak peculiar to each unit (A2: a peak peculiar to the carbonyl carbon of the acrylic acid, B2: a peak peculiar to a carbon atom of dicyclopentanyl bound to an oxygen atom of the methacryl, C2: a peak peculiar to a carbon atom of the cyclohexyl group bound to an oxygen atom of the methacryl, D2: a peak peculiar to a carbon atom of the n-butyl bound to an oxygen atom of the acryl, E2: a peak peculiar to the heptadecafluorodecyl group bound to an oxygen atom of the acryl), and its peak area ratio, as shown in FIG. 1.

### FT-IR analysis

In the FT-IR spectrum of the resulting copolymer, a peak attributed to O-H binding around 3,500 cm⁻¹, out of O-H surface bending vibration at the position of 1,386 cm⁻¹, and a peak attributed to C-O expansion and contraction vibration at the position of 1,067 cm⁻¹ are observed. Accordingly, the introduction of a hydroxymethyl group (-CH₂-OH) was verified. Preparation Example 1

### Manufacture of the acrylic copolymerized polymer (10)

750 g of isobutyl alcohol was charged into a 2-liter four necked flask equipped with a reflux condenser and a stirrer, and blowing of nitrogen was started. After the temperature was raised to 80°C while stirring, a mixture of methacrylic acid-based monomers containing acrylic acid (60 g), dicyclopentanyl methacrylate (40 g), n-butyl acrylate (40 g), cyclohexyl methacrylate (20 g) and hydroxyethyl methacrylate (40 g) (1); and another mixture of isobutyl alcohol (50 g) as a solvent, and benzoyl peroxide (1.7 g) as a polymerization initiator were dripped into the flask from separate dripping nozzles respectively over 4 hours (2). The dripping was carried out continuously while maintaining a constant drip rate for each ingredient throughout the dripping.

After the dripping was completed, the polymerization reaction solution was left for aging for 4 hours at 80°C, and again for an additional 1 hour by raising the temperature until reflux of the solvent was observed. Thus, the polymerization reaction was completed to obtain a copolymerized polymer represented by the following chemical formula (10).

The solid content in the polymerization reaction solution thus obtained was 20.2%, and the weight-average molecular weight (Mw) thereof converted into polystyrene was 18,000.

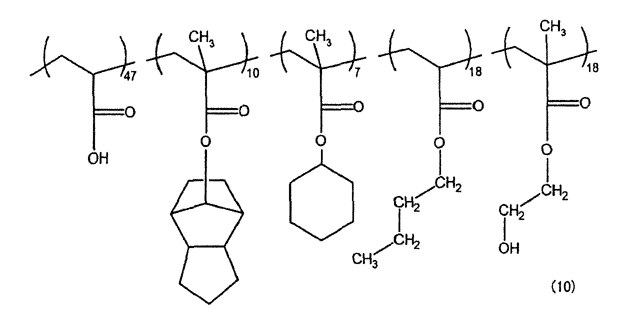

### Example 3 and 4, and Comparative Example 1

A protective film was formed using the material for forming a resist protective film including the acrylic copolymerized polymer of this invention.

As a base polymer of the material for forming a protective film, the acrylic copolymerized polymer represented by the chemical formulae (8) to (10) was used. As a solvent, 2-methyl-1-propanol (isobutyl alcohol) was used, each 2.5% by weight solution being prepared and used as a composition for forming a protective film. Note that the protective film formed using the copolymerized polymer (8) is Example 3, the protective film formed using the copolymerized polymer (9) is Example 4, and the protective film formed using the copolymerized polymer (10) is Comparative Example 1.

The composition for forming a protective film was coated onto a semiconductor substrate under coating conditions of 1500 rpm using a spin coater. After coating, a protective film for evaluation was obtained by being cured through a heat treatment at 90°C for 60 seconds. The protective film had a thickness of 170 nm.

Subsequently, the resulting protective film was rinsed with water for 120 seconds, and resistance against water was examined by measuring the film thickness of before and after the rinse. As a result, the change of film thickness in Examples 3 and 4 was little and resistance to the water was ensured. In Comparative Example 1, film decrease (the phenomenon that film thickness decreases because the surface layer of the protective film dissolves in water) was observed, and water resistance was insufficient.

### Example 5

The following resin component, acid generator, and nitrogen-containing organic compound were uniformly dissolved in an organic solvent to prepare a resist composition.

As the resin component, 100 parts by mass of a copolymer including a constituent unit represented by the following chemical formula (11) was used. The contents of the respective constituent units f, g and h used in the preparation of the resin component were respectively 40% by mole, 40% by mole and 20% by mole.

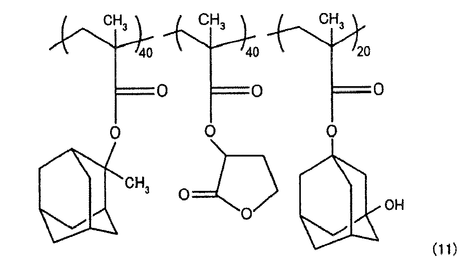

As the acid generator, 2.0 parts by mass of triphenylsulfonium nonafluorobutanesulfonate and 0.8 parts by mass of tri (tert-butylphenyl) sulfonium trifluoromethanesulfonate were used.

The resin component was dissolved in a mixed solvent of propylene glycol monomethyl ether and propylene glycol monomethyl ether acetate (mixing ratio: 6:4) as an aqueous solution having a concentration of 7.0%. As the nitrogen-containing organic compound, 0.25 parts by mass of triethanolamine was used. As the additive, 25 parts by mass of y-butyrolactone was added.

Using the resist composition thus prepared, a resist pattern was formed. First, an organic antireflective film composition "ARC29" (trade name, manufactured by Brewer Co.) was coated on a silicone wafer using a spinner and then dried by baking on a hot plate at 205°C for 60 seconds to form an organic antireflective film having a thickness of 77 nm. Subsequently, the resist composition was coated on this antireflective film using a spinner and dried by prebaking on a hot plate at 130°C for 90 seconds to form a resist film having a thickness of 225 nm on the antireflective film.

The copolymerized polymer (MW 20,000) (Example 1) represented by the chemical formula (8), was dissolved in 2-methyl-1-propylalcohol to adjust the resin concentration of 2.5% by mass. Thus prepared material for the protective film was spin-coated on the resist film, and then heated at 90°C for 60 seconds to form a protective film having a thickness of 70 nm.

Next, a pattern light was irradiated (exposed) through a mask pattern using an ultraviolet ray (wavelength 193 nm) of a NST-S302A lithography machine (by Nikon Co.). Then, as the treatment of liquid immersion lithography, purified water was dripped continuously onto the resist film at 23°C for 2 minutes while rotating the exposed silicon wafer. The process of this portion is a process of exposing in a completely immersed state in an actual production process. The present invention has such a simple constitution that, first, the resist film is exposed, and then pure water as a liquid for liquid immersion lithography is loaded on a resist film after the exposure so that only an influence of the liquid for liquid immersion lithography on the resist film can be evaluated. In this liquid immersion lithography process, a 8-inch silicon wafer was used to form line-and-space of 130 nm.

After the process of dropping pure water, a PEB treatment was conducted at 115°C for 90 seconds. Then, without removing the protective film, the film was developed using an alkaline developing solution at 23°C for 60 seconds. As the alkaline developing solution, an aqueous 2.38% by mass tetramethylammonium hydroxide solution was used. The protective film was completely removed by this development process and the development of the resist film could be satisfactorily realized, and line-and-space of 130 nm could be formed.

### Example 6

A 130 nm line and space pattern was formed similarly to Example 5 with the same ingredient, ingredient amounts, and operation except that the acrylic copolymerized polymer (9) (Example 2) was used. Thus, a favorable 130 nm line and space pattern formation of good rectangle shape was formed as described above.

### INDUSTRIAL APPLICABILITY

As discussed above, use of the acrylic copolymerized polymer of this invention as a material for forming a protective film can prevent the change in quality of the resist pattern, and deterioration of the liquid for liquid immersion lithography itself. Therefore it is possible to provide a material for forming a resist protective film, which can form a protective film capable of surely protecting a resist film from a liquid for liquid immersion lithography in liquid immersion lithography. Consequently, when a protective film of the present invention is used, a resist pattern can be effectively formed using a liquid immersion lithography process.

## Claims

1. An acrylic copolymerized polymer comprising a constituent unit represented by the following general formula (1): 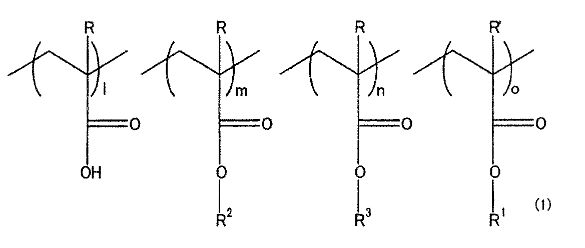 wherein R is a hydrogen atom or a methyl group; R' is a hydrogen atom, a methyl group, or a hydroxyalkyl group having 1 to 4 carbon atoms; R¹ is a linear, branched or cyclic alkyl group having 1 to 15 carbon atoms, and a portion or all of hydrogen atoms thereof may be substituted with a fluorine atom; R² is an alicyclic hydrocarbon group; R³ is a chain hydrocarbon group; and 1, m, n, and o each representing % by mole of the constituent unit in the polymer, are each 2 to 60% by mole.

2. The acrylic copolymerized polymer according to claim 1 to be included in a material for forming a resist protective film that is used for forming an upper protective film on a resist film.

3. The acrylic copolymerized polymer according to claim 2, wherein the resist film is to be subjected to a liquid immersion lithography process.

4. The acrylic copolymerized polymer according to claim 1, wherein R' is a hydroxy alkyl group having 1 to 4 carbon atoms in the above general formula (1).

5. The acrylic copolymerized polymer according to claim 1 wherein R¹ is represented by the following general formula (2): 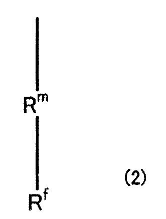 wherein R^{m} is a linear or branched alkylene group having 1 to 5 carbon atoms, and R^{f} is an alkyl group having 1 to 15 carbon atoms, and a portion or all of hydrogen atoms thereof are substituted with a fluorine atom.

6. The acrylic copolymerized polymer according to claim 1, wherein the constituent unit having R² in the above general formula (1) comprises a constituent unit having R^{2a} and R^{2b} wherein R^{2a} is a polycyclic hydrocarbon group, and R^{2b} is a monocyclic hydrocarbon group.

7. The acrylic copolymerized polymer according to claim 6, wherein R^{2a} is at least one hydrocarbon group selected from a dicyclopentanyl group, an adamantyl group, a norbonyl group, an isobornyl group, a tricyclodecyl group and a tetracyclododecyl group.

8. The acrylic copolymerized polymer according to claim 6, wherein R^{2b} is at least one hydrocarbon group selected from a cyclohexyl group, a cyclopentyl group and a cycloheptyl group.

9. The acrylic copolymerized polymer according to claim 1, wherein R³ is at least one hydrocarbon group selected from a n-butyl group, a n-pentyl group, a 2-ethylhexyl group, and a n-hexyl group.
